# EUROPEAN PATENT APPLICATION

(11) **EP 2 650 931 A1**
(43) Date of publication of application: **16.10.2013**
(21) Application number: 11847521.9
(22) Date of filing: 03.10.2011
(51) Int. Cl.: H01L 31/20, C23C 16/56

(54) **METHOD FOR MANUFACTURING SOLAR CELL**

(30) Priority: 07.12.2010 JP 2010272620
(71) Applicant: Fuji Electric Co. Ltd., Kanagawa 210-9530 (JP)
(72) Inventor: SHIMOSAWA, Makoto, Kawasaki-shi Kanagawa 210-9530 (JP)
(74) Representative: MERH-IP Matias Erny Reichl Hoffmann
(86) International application number: PCT/JP2011/072726
(87) International publication number: WO 2012/077401

(57) **Abstract**

Provided is a method for manufacturing a photovoltaic cell capable of efficiently preventing deterioration of photoelectric conversion performance caused by adhesion of a foreign substance and occurrence of leakage without lowering manufacturing efficiency. The method for manufacturing a photovoltaic cell having a structure in which a first electrode, a photoelectric conversion layer and a second electrode are laminated on one surface of a substrate in this order, and the photoelectric conversion layer is arranged as a multi-junction type photoelectric conversion layer in which a plurality of photoelectric conversion units are laminated while each photoelectric conversion unit has a plurality of layers, the method including at least one step in which a surface of a layer formed in a process after the thickest layer in a photoelectric conversion unit is formed and before the thickest layer in any one of photoelectric conversion units further laminated is formed is washed in the process.

## Description

### TECHNICAL FIELD

The present invention relates to a method for manufacturing a photovoltaic cell having a laminate structure in which a first electrode, a photoelectric conversion layer and a second electrode are laminated on one surface of a substrate in this order.

### BACKGROUND ART

Photovoltaic cells include Si (silicon) based thin-film photovoltaic cells, compound based photovoltaic cells using no Si, etc. Generally, in such a photovoltaic cell, a first electrode, a photoelectric conversion layer and a second electrode are laminated on a permeable or impermeable substrate in this order. When the substrate is permeable, sunlight can be incident on both the first electrode and the second electrode, and both the first electrode side and the second electrode side of the photovoltaic cell can be set as light receiving sides. On the other hand, when the substrate is impermeable, the second electrode side of the photovoltaic cell is set as a light receiving side. A transparent electrode is used as such a light receiving side electrode. On the other hand, a low-resistance electrode is used as the opposite electrode to the light receiving side. A transparent electrode may be used as this electrode. In addition, the surface of each electrode is often formed into a textured shape in order to make incident light stay within the photoelectric conversion layer for a long time while increasing the amount of absorbed light. A method performing treatment such as sputtering or deposition using a vacuum apparatus is generally used as a method for forming such an electrode.

A plasma CVD method, a sputtering method, a deposition method, etc. are often used as a method for forming the photoelectric conversion layer as a film. A pn type photoelectric conversion unit in which a p type semiconductor and an n type semiconductor are joined, a pin type photoelectric conversion unit in which a substantially intrinsic i type semiconductor is disposed between a p type semiconductor and an n type semiconductor, etc. are used as the photoelectric conversion layer. In addition, there are a single-junction type photoelectric conversion layer composed of a single layer of a photoelectric conversion unit, a multi-junction type photoelectric conversion layer composed of two or more layers of photoelectric conversion units, etc.

Here, description will be made on the structure of the photoelectric conversion layer. In the case of a pin type photoelectric conversion unit, the film thickness of the i layer is set to be larger than that of the p layer or the n layer because the photoelectric conversion performance of the i layer substantially engaging in converting light into electricity in the photoelectric conversion layer is proportional to the film thickness of the i layer to some extent. For example, the optimal film thickness of the i layer is regarded as about 50 nm to 500 nm in the case of an a-Si based photovoltaic cell, and as about 1 µm to 3 µm in the case of a microcrystal Si based photovoltaic cell. On the other hand, the p layer and the n layer do not have substantial contribution to the photoelectric conversion function, but the light absorbed by these layers causes an absorption loss. Therefore, the film thicknesses of the p layer and the n layer are set to be as thin as about several percent to several tens of percent of the film thickness of the i layer. Further, an interface layer may be disposed between the i layer and the p layer or the n layer if necessary. The pin type photoelectric conversion unit is thus composed of the i layer, the p layer and the n layer.

An example of a Si based thin-film photovoltaic cell having the aforementioned i layer includes a tandem type photovoltaic cell in which a-Si (amorphous silicon) and a-SiGe (amorphous silicon germanium) are used as i layer materials and two photoelectric conversion units are laminated. In this tandem type photovoltaic cell, the optical band gap (Eg) in the a-SiGe film can be changed in accordance with the content of Ge in the film. Therefore, the optical band gap of the a-SiGe film is made narrower than that of the a-Si film, and photoelectric conversion units using the a-Si film and the a-SiGe film as the i layers respectively are laminated so that sunlight can be absorbed efficiently. Thus, the efficiency of the photovoltaic cell can be made high. In addition, the multi-junction type photovoltaic cells include a tandem type having two layers of photoelectric conversion units, a triple type having three layers of photoelectric conversion units, a multi-junction type having four or more layers of photoelectric conversion units, etc. When the number of laminated layers is increased while i layers having suitably controlled optical band gaps are used, sunlight can be absorbed efficiently.

There is another silicon based thin-film photovoltaic cell using a series connection structure, which is called SCAF (Series Connection through Apertures formed on Film). In this series connection structure, a thin-film photovoltaic cell which is split into a plurality of regions by laser patterning is formed, and a plurality of thin-film photovoltaic cells split by a plurality of through holes penetrating a substrate are connected in series.

On the other hand, examples of the compound based photovoltaic cell include a CIGS based photovoltaic cell in which a pn junction is formed out of a p type CIGS layer and an n type CdS layer in a photoelectric conversion layer, a CdTe based photovoltaic cell in which a pn junction is formed out of a p type CdTe layer and an n type CdS layer in a photoelectric conversion layer, etc. Particularly, the optical band gap of the CIGS layer can be changed by changing the additive amounts of Ga (gallium) and S (sulfur). Therefore, when a multi-junction type photoelectric conversion layer in which a plurality of photoelectric conversion units are laminated is used in the CIGS based photovoltaic cell, sunlight can be absorbed efficiently.

On the other hand, in the case of a pn type photoelectric conversion unit, the film thickness of one conductive type layer (p layer or n layer) is set to be larger than the film thickness of the other conductive type layer so that a substantial photoelectric conversion function is often given to the thicker conductive type layer. For example, a photoelectric conversion unit of a CIGS based photovoltaic cell is formed out of a junction between a p type CIGS layer about 1 µm to 3 µm thick and an n type CdS layer about 50 nm to 100 nm thick. In this case, the p type CIGS layer serves as a layer which substantially converts light into electricity. A photoelectric conversion unit of a CdTe based photovoltaic cell is formed out of a junction between an n type CdS layer about 50 nm to 100 nm thick and a p type CdTe layer about 3 µm to 7 µm thick. In this case, the p type CdTe layer serves as a layer which substantially converts light into electricity.

As a substrate used for forming such a thin-film photovoltaic cell, a glass substrate, a stainless steel substrate, a plastic substrate or the like is used. When a glass substrate is used as the substrate, thin films are formed on the substrate chiefly by batch processing. When a flexible substrate such as a stainless steel substrate or a plastic substrate is used as the substrate, films are often formed on the substrate conveyed by a roll conveyance system such as a roll-to-roll system or a stepping roll system.

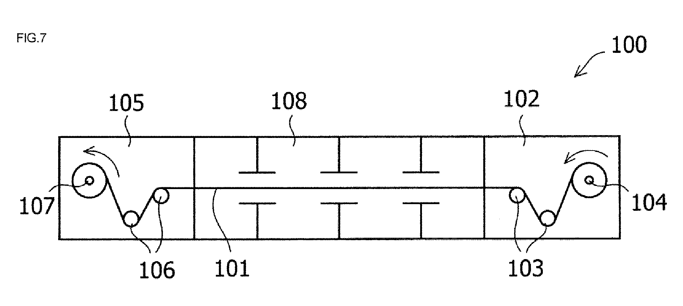

For example, in an apparatus 100 for manufacturing a photovoltaic cell in a typical roll conveyance system as shown in Fig. 7, one longitudinal end of a substrate 101 is guided by guide rolls 103 and unwound from an unwind roll 104 in an unwind chamber 102, while the other longitudinal end of the substrate 101 is guided by guide rolls 106 and wound on a wind roll 107 in a wind chamber 105. Further, in this manufacturing apparatus 100, a plurality of film formation chambers 108 are disposed between the unwind chamber 102 and the wind chamber 105 so that thin films can be formed on the substrate 101 in the film formation chambers 108.

When a film formation method such as a plasma CVD method, a sputtering method or a deposition method is used in such photovoltaic cell manufacturing, a foreign substance may adhere to thin films which are being formed. Examples of the foreign substance include a thin film adhering to the inner wall of a vacuum vessel and then peeled off, a reaction by-product generated during plasma application in the plasma CVD method, etc.
When a foreign substance adheres to films that are being formed, there is a possibility that the photoelectric conversion performance may deteriorate due to the generation of a pin hole etc. According to Patent Literature 1, thin films are formed in a plurality of batches. A foreign substance adhering to an insulating thin film that is being formed on a conductive substrate is removed in a washing step. In order to bury a pin hole generated by the removal of the foreign substance, the same kind of insulating thin film is formed again to be laminated on the insulating thin film after the washing.

### CITATION LIST

### PATENT LITERATURE

Patent Literature 1: JP-A-3-267362

### SUMMARY OF INVENTION

### TECHNICAL PROBLEM

Foreign substances adhering to films that are being formed include substances with various sizes from the nm order to the µm order. The size of a foreign substance may be larger than the total thickness of a photoelectric conversion layer. When a foreign substance adheres to a photoelectric conversion layer that is being formed as films, no thin film is substantially formed in the portion to which the foreign substance adheres, so that there is a problem that the photoelectric conversion performance deteriorates. In addition, when a foreign substance that is larger than the total thickness of a photoelectric conversion layer adheres to the photoelectric conversion layer that is being formed or that has been formed in manufacturing of the photovoltaic cell using a roll conveyance system for conveying a flexible substrate, the substrate from which the foreign substance is not removed may be wound on a roll. In such a state, the foreign substance is pressed onto the surface of the photoelectric conversion layer due to the tension of the substrate or the like so that the photoelectric conversion layer around the foreign substance may be broken by the foreign substance. As a result, there is a problem that a first electrode and a second electrode touch each other to cause leakage.

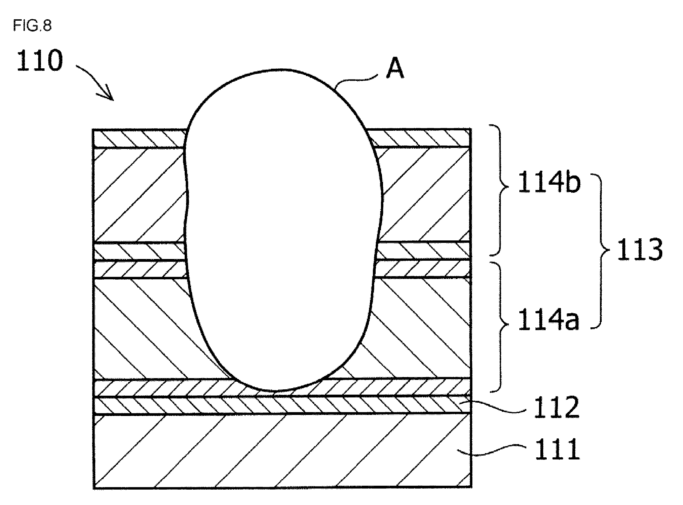

Another problem caused by the foreign substance adhering to films that are being formed will be described in the case where a foreign substance A adheres to a pin type and tandem type photovoltaic cell 110 that is being formed as shown in Fig. 8, by way of example. In the photovoltaic cell 110, a first electrode 112 is formed on a substrate 111, and a photoelectric conversion layer 113 is formed on the first electrode 112. The photoelectric conversion layer 113 is composed of a first photoelectric conversion unit 114a and a second photoelectric conversion unit 114b. In the configuration here, a not-shown second electrode is formed on the photoelectric conversion layer 113. Assume that the foreign substance A whose size is equal to or larger than the thickness of such a photoelectric conversion layer 113 adheres thereto due to a force such as static electricity when the first photoelectric conversion unit 114a of the photoelectric conversion layer 113 is being formed. In this case, after the adhesion of the foreign substance A, a film in the first photoelectric conversion unit 114a of the photoelectric conversion layer 113 and a film in the second photoelectric conversion unit 114b are formed while the foreign substance A is avoided. Here, when the adhering foreign substance A is removed after the photoelectric conversion layer 113 is formed, a pin hole is formed in the portion where the foreign substance A adhered. The film thickness of the photoelectric conversion layer 113 in the place where the pin hole is formed is thinner than that of its peripheral portion, or a part of the first electrode 112 may be exposed in some cases. When the second electrode (not shown) is formed as a film in this state, the first electrode and the second electrode are arranged to touch each other or to face each other with interposition of the extremely thin photoelectric conversion layer. On this occasion, there arises a problem as follows. That is, when the first electrode and the second electrode touch each other, that portion serves as a leak path. Also when the first electrode and the second electrode face each other with interposition of the extremely thin photoelectric conversion layer, a leak path may be formed easily because the insulating distance between the electrodes is short locally at that place.

However, as for the case where the deterioration of the photoelectric conversion performance caused by the adhesion of a foreign substance and the occurrence of leakage are avoided in the method of Patent Literature 1, Patent Literature 1 indeed has given description about a method for simply burying a pin hole after washing. However, Patent Literature 1 has not given any disclosure about the timing and so on for introduction of the washing step in consideration of the relation between the film thicknesses of thin films formed before and after the washing step, the influence on the photoelectric conversion function, etc.

The present invention has been accomplished in consideration of such actual circumstances. An object of the invention is to provide a method for manufacturing a photovoltaic cell capable of efficiently preventing the deterioration of the photoelectric conversion performance caused by the adhesion of a foreign substance and the occurrence of leakage.

### SOLUTION TO PROBLEM

In order to solve the problem, the method for manufacturing a photovoltaic cell according to the invention is a method for manufacturing a photovoltaic cell including a structure in which a first electrode, a photoelectric conversion layer and a second electrode are formed on one surface of a substrate in this order, and the photoelectric conversion layer is consisted of plural photoelectric conversion units and arranged as a multi-junction type photoelectric conversion layer, and the photoelectric conversion units are consisted of plural layers,
the method including
one cleaning step between fabrication process of the layer which is the thickest in the bottom photovoltaic conversion unit and in the top photovoltaic conversion unit, and the surface of a layer during fabricating a photoelectric conversion unit is cleaned in that process.

The method for manufacturing a photovoltaic cell according to the invention further includes the step of applying a reverse voltage between the first electrode and the second electrode after the second electrode is formed.

The method for manufacturing a photovoltaic cell according to the invention includes the step of exposing the surface which is cleaned in the cleaning step to hydrogen, argon and/or CF4 plasma.

In the method for manufacturing a photovoltaic cell according to the invention, the film thickness of the layer which is cleaned is fabricated thicker than that of the design value, and then the layer is etched by exposing hydrogen, argon and/or CF4 plasma treatment to fit the film thickness of the layer as the design value.

In the method for manufacturing a photovoltaic cell according to the invention, the cleaning step is progressed by contacting the cleaning roll to the surface physically.

In the method for manufacturing a photovoltaic cell according to the invention, the cleaning roll is selected in a brush roll, an adhesive roll or a sponge roll.

In the method for manufacturing a photovoltaic cell according to the invention, each of the photoelectric conversion units has a pin junction structure or an nip junction structure.

In the method for manufacturing a photovoltaic cell according to the invention, plural i layers in each of the photoelectric conversion units are made of non crystalline silicon , and the film thickness of each i layer is the thickest in each photoelectric conversion unit.

In the method for manufacturing a photovoltaic cell according to the invention, the i layer provided in at least one of the photoelectric conversion units is an amorphous silicon layer or an amorphous silicon alloy layer, and the film thickness of the i layer is in a range from 50 nm to 500 nm.

In the method for manufacturing a photovoltaic cell according to the invention, the i layer provided in at least one of the photoelectric conversion units is a microcrystal silicon layer or a microcrystal silicon alloy layer, and the film thickness of the i layer is in a range from 1 µm to 3 µm.

In the method for manufacturing a photovoltaic cell according to the invention, each of the photoelectric conversion units has a pn junction structure or an np junction structure.

In the method for manufacturing a photovoltaic cell according to the invention, a p layer provided in each of the photoelectric conversion units is selected in a CIS layer, a CIGS layer or a CdTe layer, and the film thickness of the p layer is thicker than that of the n layer in the photoelectric conversion unit.

In the method for manufacturing a photovoltaic cell according to the invention, the p layer provided in at least one of the photoelectric conversion units is a CIS layer or a CIGS layer, and the film thickness of the p layer is in a range from 1 µm to 3 µm.

In the method for manufacturing a photovoltaic cell according to the invention, the p layer provided in at least one of the photoelectric conversion units is a CdTe layer, and the film thickness of the p layer is in a range from 3 µm to 7 µm.

In the method for manufacturing a photovoltaic cell according to the invention, the cleaning step is progressed at the surface of an np reverse junction.

### ADVANTAGEOUS EFFECTS OF INVENTION

According to the invention, the following effects can be obtained.
The method for manufacturing a photovoltaic cell according to the invention relates to a method for manufacturing a photovoltaic cell including a structure in which a first electrode, a photoelectric conversion layer and a second electrode are laminated on one surface of a substrate in this order, and the photoelectric conversion layer is arranged as a multi-junction type photoelectric conversion layer in which a plurality of photoelectric conversion units are laminated while each of the photoelectric conversion units has a plurality of layers. The method for manufacturing the photovoltaic cell includes at least one step in which a surface of a layer formed in a process after the thickest one of the layers in the bottom one of the photoelectric conversion units formed on the first electrode is formed and before the thickest one of the layers in the top one of the photoelectric conversion units is formed is washed in the process.
Accordingly, a pin hole generated after a foreign substance is removed by the washing and in the layers that have been laminated till the washing can be buried with layers laminated after the washing. In addition, the layers with which the pin hole is buried include the thickest layer in the photoelectric conversion unit laminated next. It is therefore possible to efficiently preventing the deterioration of the photoelectric conversion performance caused by the adhesion of the foreign substance and the occurrence of leakage without remarkably lowering the resistance between the first electrode and the second electrode in the place where the pin hole is generated.

The method for manufacturing the photovoltaic cell according to the invention further includes the step of applying a reverse voltage between the first electrode and the second electrode after the second electrode is formed. Accordingly, a leak source can be removed due to the application of the reverse voltage so as to further efficiently prevent the deterioration of the photoelectric conversion performance caused by the adhesion of the foreign substance and the occurrence of leakage.

The method for manufacturing the photovoltaic cell according to the invention includes the step of applying hydrogen plasma treatment, argon plasma treatment or CF4 plasma treatment to the washed surface after the washing. Accordingly, the superficial layer of the washed surface degraded or contaminated by the washing is removed so that the surface can be well joined to a layer that is formed further thereon. It is therefore possible to improve the photoelectric conversion performance of the photovoltaic cell, with the result that it is possible to prevent the deterioration of the photoelectric conversion performance caused by the adhesion of the foreign substance.

In the method for manufacturing the photovoltaic cell according to the invention, film thickness of a layer to be washed is formed to be thicker than a designed film thickness in advance before the washing, and etching is performed by applying the hydrogen plasma treatment, the argon plasma treatment or the CF4 plasma treatment to the washed surface after the washing so as to make the film thickness of the washed layer as large as the predetermined designed film thickness. Accordingly, the film thickness of the washed layer can be prevented from being made thinner than the predetermined designed film thickness due to the washing.

In the method for manufacturing the photovoltaic cell according to the invention, the washing is performed by bringing a washing roll into contact with the washed surface. In addition, the washing roll is a brush roll, a sticky roll or a sponge roll.
Accordingly, the surface of each of the photoelectric conversion units or the surface of each of the semiconductor layers can be washed surely. It is therefore possible to efficiently prevent the deterioration of the photoelectric conversion performance caused by the adhesion of the foreign substance and the occurrence of leakage.

In the method for manufacturing the photovoltaic cell according to the invention, each of the photoelectric conversion units has a pin junction structure or an nip junction structure. It is possible to efficiently prevent the deterioration of the photoelectric conversion performance caused by the adhesion of the foreign substance and the occurrence of leakage as to a photovoltaic cell having a pin junction structure or an nip junction structure.

In the method for manufacturing the photovoltaic cell according to the invention, an i layer provided in each of the photoelectric conversion units is a non-single-crystal silicon based film, and the i layer is the thickest among a p layer, the i layer and an n layer in the photoelectric conversion unit.
The i layer provided in at least one of the photoelectric conversion units is an amorphous silicon layer or an amorphous silicon alloy layer, and the film thickness of the i layer is in a range of from 50 nm to 500 nm. Alternatively, the i layer provided in at least one of the photoelectric conversion units is a microcrystal silicon layer or a microcrystal silicon alloy layer, and the film thickness of the i layer is in a range of from 1 µm to 3 µm.
Thus, as to a photovoltaic cell having a pin junction structure or an nip junction structure in which an i layer serving as the photoelectric conversion layer is a non-single-crystal silicon based film, the film thickness of the i layer is thick enough to bury pin holes. It is therefore possible to efficiently prevent the deterioration of the photoelectric conversion performance caused by the adhesion of the foreign substance and the occurrence of leakage.

In the method for manufacturing the photovoltaic cell according to the invention, each of the photoelectric conversion units has a pn junction structure or an np junction structure. It is therefore possible to efficiently prevent the deterioration of the photoelectric conversion performance caused by the adhesion of the foreign substance and the occurrence of leakage as to a photovoltaic cell having a pn junction structure or an np junction structure.

In the method for manufacturing the photovoltaic cell according to the invention, a p layer provided in each of the photoelectric conversion units is one of a CIS layer, a CIGS layer and a CdTe layer, and the p layer is the thickest between the p layer and an n layer in the photoelectric conversion unit.
The p layer provided in at least one of the photoelectric conversion units is a CIS layer or a CIGS layer, and the film thickness of the p layer is in a range of from 1 µm to 3 µm. Alternatively, the p layer provided in at least one of the photoelectric conversion units is a CdTe layer, and the film thickness of the p layer is in a range of from 3 µm to 7 µm.
Thus, as to a photovoltaic cell having a pn junction structure or an np junction structure in which a p layer serving as the photoelectric conversion layer is thicker than an n layer, the film thickness of the p layer is thick enough to bury a pin hole. It is therefore possible to efficiently prevent the deterioration of the photoelectric conversion performance caused by the adhesion of the foreign substance and the occurrence of leakage.

In the method for manufacturing the photovoltaic cell according to the invention, the washing step is carried out between film formation of an n layer and film formation of a p layer in an np reverse junction. Accordingly, the surface of each of the photoelectric conversion units can be washed surely without contaminating any interface layer in the photoelectric conversion unit. It is therefore possible to efficiently prevent the deterioration of the photoelectric conversion performance caused by the adhesion of the foreign substance and the occurrence of leakage.

### BRIEF DESCRIPTION OF DRAWINGS

[Fig. 1] Fig. 1 is a sectional view schematically showing a laminate structure of a photovoltaic cell in a first embodiment of the invention.
[Fig. 2] Fig. 2 is a view schematically showing an equivalent circuit of the photovoltaic cell in the first embodiment of the invention.
[Fig. 3] Fig. 3 is a sectional view schematically showing a portion from which a foreign substance has been removed in the laminate structure of the photovoltaic cell in the first embodiment of the invention.
[Fig. 4] Fig. 4 is a sectional view schematically showing a laminate structure of a photovoltaic cell in a second embodiment of the invention.
[Fig. 5] Fig. 5 is a sectional view schematically showing a laminate structure of a photovoltaic cell in a third embodiment of the invention.
[Fig. 6] Fig. 6 is a sectional view schematically showing a laminate structure of a photovoltaic cell in a fourth embodiment of the invention.
[Fig. 7] Fig. 7 is a view schematically showing an apparatus for manufacturing a photovoltaic cell in a typical roll conveyance system.
[Fig. 8] Fig. 8 is a sectional view schematically showing a state where a foreign substance adheres to a photovoltaic cell in which a photoelectric conversion layer has been formed without washing.

### DESCRIPTION OF EMBODIMENTS

### [First Embodiment]

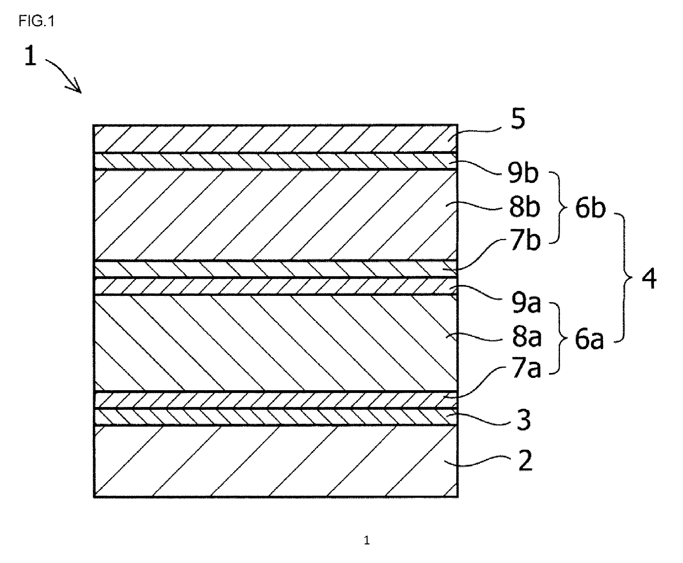

A method for manufacturing a photovoltaic cell in a first embodiment of the invention will be described below. As shown in Fig. 1, a photovoltaic cell 1 in the first embodiment of the invention has a laminate structure in which a first electrode 3, a photoelectric conversion layer 4 and a second electrode 5 are laminated on one surface of a substrate 2 in this order. An impermeable plastic substrate is used as the substrate 2, and the second electrode 5 side serves as the light receiving side. A heat-resistant plastic substrate such as a PI (polyimide) based film, a PEN (polyethylene naphthalate) based film, a PES (polyether sulfone) based film, a PET (polyethylene terephthalate) based film, an aramid based film, etc. may be used for an impermeable flexible substrate as the substrate 2. Moreover, a conductive substrate such as stainless steel foil, or a glass substrate or the like other than flexible substrates may be used as the substrate 2.

The first electrode 3 is arranged to be capable of reflecting sunlight. The surface of the first electrode 3 is formed into a textured shape to scatter incident sunlight from the light receiving side and increase the amount of absorption in the photoelectric conversion layer 4. An Ag (silver) electrode is used as the first electrode 3. A laminate film in which a film of TiO₂ having plasma durability is formed on the surface of the Ag electrode, a material that can be formed into an optimal textured shape, etc. may be used for the first electrode 3. The second electrode 5 is arranged to allow sunlight to enter therein. ITO is used for the second electrode 5. Incidentally, SnO₂, ZnO, etc. may be used for the second electrode 5.

The photoelectric conversion layer 4 has a first photoelectric conversion unit 6a laminated on the first electrode 3 and a second photoelectric conversion unit 6b laminated on the first photoelectric conversion unit 6a. The photovoltaic cell 1 is of a tandem type. The first photoelectric conversion unit 6a has a laminate structure in which a first n layer 7a, a first i layer 8a as a substantially intrinsic layer, and a first p layer 9a are laminated in this order. The first i layer 8a is thicker than the first n layer 7a and the first p layer 9a. The second photoelectric conversion unit 6b has a laminate structure in which a second n layer 7b, a second i layer 8b as a substantially intrinsic layer, and a second p layer 9b are laminated in this order. The second i layer 8b is thicker than the second n layer 7b and the second p layer 9b. Each photoelectric conversion unit may be arranged so that a p layer, an i layer and an n layer are laminated in this order.

a-SiO (amorphous silicon oxide) is used for the first n layer 7a and the first p layer 9a, and a-SiGe (amorphous silicon germanium) is used for the first i layer 8a. a-SiO (amorphous silicon oxide) is used for the second n layer 7b and the second p layer 9b, and a-Si (amorphous silicon) is used for the second i layer 8b. In place of a-Si and a-SiGe, a-SiC (amorphous silicon carbide), a-SiO (amorphous silicon oxide), a-SiN (amorphous silicon nitride), µc-Si (microcrystal silicon), µc-SiGe (microcrystal silicon germanium), µc-SiC (microcrystal silicon carbide), µc-SiO (microcrystal silicon oxide), µc-SiN (microcrystal silicon nitride), etc. may be used for the first i layer 8a and the second i layer 8b. The aforementioned materials for the i layer added with a suitable content of B (boron), P (phosphorus), etc. may be used for the first n layer 7a, the second n layer 7b, the first p layer 9a and the second p layer 9b.

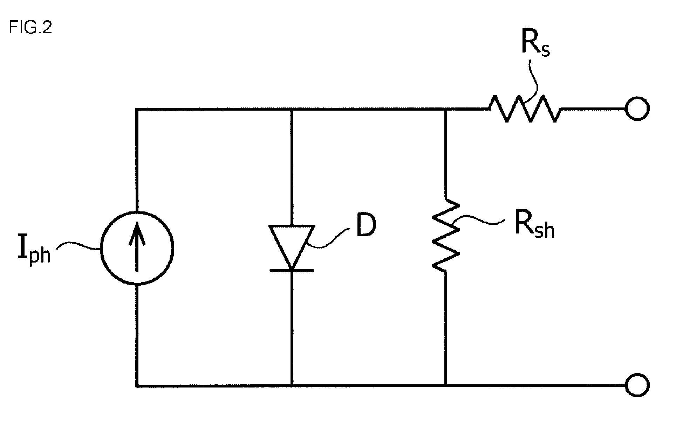

Next, an equivalent circuit of the photovoltaic cell 1 will be described with reference to Fig. 2. The equivalent circuit provided in the photovoltaic cell 1 has a constant current source Iₚₕ, a serial resistance Rₛ, a parallel resistance Rₛₕ, and a diode D. The constant current source Iₚₕ, the diode D and the parallel resistance Rₛₕ are connected in parallel, and the serial resistance Rₛ is connected in series with the parallel circuit portion. A leak current flowing in a portion where leakage occurs is expressed by a current flowing in an opposite direction to the pn junction in the parallel resistance Rₛₕ.

The method for manufacturing the photovoltaic cell 1 according to the first embodiment of the invention will be described with reference to Fig. 1.
The first electrode 3 is formed as a film on the surface of the substrate 2. A plasma CVD method is used to form films of the first photoelectric conversion unit 6a in such a manner that the first n layer 7a is formed as a film so as to be laminated on the first electrode 3, and the first i layer 8a and the first p layer 9a are formed as films so as to be laminated on the first n layer 7a. Next, washing is performed in such a manner that a brush roll as a washing roll is rotated and brought into contact with the surface of the first p layer 9a. Further, in some cells, hydrogen plasma treatment is applied to the surface of the first p layer 9a after the washing. The washed surface is etched by the hydrogen plasma treatment. The etching rate on this occasion often varies in accordance with the kind of film (a-Si, a-SiGe, µc-Si, etc.) in the washed surface. Therefore, when a film that is easy to etch is exposed in the surface, the hydrogen plasma treatment may be carried out with a comparatively low power for a short time so that the hydrogen plasma treatment can be applied only to the very superficial surface. When a film that is difficult to etch is exposed in the surface, the impact of etching is low. Therefore, the hydrogen plasma treatment may be carried out with a comparatively high power so that the hydrogen plasma treatment can be applied only to the very superficial surface. Preferably, in consideration of the amount of etched thickness in advance, the film to be subjected to the hydrogen plasma treatment is formed to be thicker than the layer thickness determined based on a designed value, so that the film thickness can be made as large as the designed film thickness by the etching. In addition, it is preferable that the etching rate is controlled by plasma conditions etc. so as to prevent the etching from going on beyond necessity. In this embodiment, in some cells, the first p layer 9a is formed to be 1.2 times as thick as the designed film thickness when the first p layer 9a is formed as a film. After the surface of the first p layer 9a is washed, hydrogen plasma treatment is applied thereto so that the first p layer 9a is made as large as the designed film thickness. Here, as for the conditions of the hydrogen plasma treatment, the period of the treatment, etc., preliminary experiments are carried out in advance, and conditions obtained therefrom are used.

After that, films of the second photoelectric conversion unit 6b are formed in such a manner that the second n layer 7b is formed as a film so as to be laminated on the first p layer 9a, the second i layer 8b is formed as a film so as to be laminated on the second n layer 7b, and the second p layer 9b is formed as a film so as to be laminated on the second i layer 8b. After that, the second electrode 5 is formed as a film so as to be laminated on the second p layer 9b. Incidentally, a sputtering method, a deposition method, a Cat-CVD method, an optical CVD method, etc. may be used for forming films of the layers in the first photoelectric conversion unit 6a and the second photoelectric conversion unit 6b. In the first embodiment, the film thickness of each of the i layers is designed to be 100 nm to 300 nm, and the film thickness of each of the p layers and the n layers is designed to be 10 nm to 30 nm.

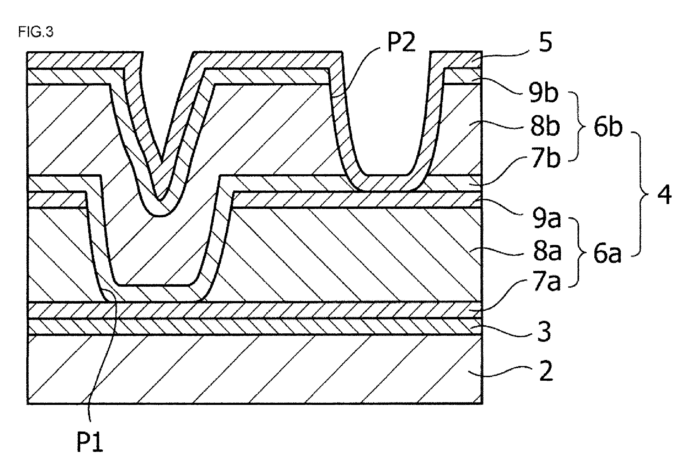

The effect that the characteristic of the photovoltaic cell is improved by washing in the first embodiment of the invention will be described with reference to Fig. 3. Assume that when films of the first photoelectric conversion unit 6a are being formed, a foreign substance adhered to the surface of a grown film, and the foreign substance is removed by washing. In this case, it is expected that a pin hole P1 is formed in the portion where the foreign substance has been removed by washing, and films of the second photoelectric conversion unit 6b are formed to bury the pin hole P1, as shown in Fig. 3. Therefore, the second photoelectric conversion unit 6b including the second i layer 8b is interposed between the first electrode 3 and the second electrode 5 in the portion of the pin hole P1. The film thickness of the portion where the pin hole P1 is generated is at least 100 nm, and an insulating film which is about half as thick as the total thickness of the photoelectric conversion layer adheres thereto. In this case, a pin hole penetrating the photoelectric conversion layer as a whole, as described above in Fig. 8, can be prevented from being generated by the foreign substance.

On the other hand, when a pin hole P2 penetrating the second photoelectric conversion unit 6b is formed as shown in Fig. 3 after the surface of the first p layer 9a is washed, it is expected that the probability of overlap between the position of the pin hole P1 and the position of the pin hole P2 is extremely low. Therefore, there is no case where the photoelectric conversion layer 4 is thoroughly penetrated due to the formation of the pin hole P2. Further, the first photoelectric conversion unit 6a including the first i layer 8a is interposed between the first electrode 3 and the second electrode 5 in the portion of the pin hole P2. The film thickness of the portion of the pin hole P2 is at least 100 nm, and an insulating film which is about half as thick as the total thickness of the photoelectric conversion layer adheres thereto.

In the region of the pin hole P1 and the region of the pin hole P2, the parallel resistance Rₛₕ is relatively lower than that in any other region. The possibility that leakage may be caused by the pin holes in the photovoltaic cell 1 in such a condition can't be denied. However, when a reverse voltage is applied to the photovoltaic cell 1 in such a condition so as to make a current flow in the opposite direction to the pn junction, the current flows into the region of the pin hole P1 and the region of the pin hole P2 selectively. As a result, Joule heat is applied to the region of the pin hole P1 and the region of the pin hole P2 so that the leak occurrence portion can be removed. Here, when the film thickness of each photoelectric conversion unit burying the pin holes is extremely thin, or when the first electrode 3 and the second electrode 5 come in direct contact with each other, enough Joule heat is not generated even if the reverse current is applied to the leak portion. It is therefore impossible to remove the leak occurrence portion satisfactorily. As a result of preliminary investigation, the film thickness of the thickest layer in each photoelectric conversion unit is required to be made not smaller than 50 nm, preferably not smaller than 100 nm in order to remove any leak occurrence portion in the pin hole regions.

Although the example in which washing is performed once after the first i layer 8a is formed as a film is shown as an example of the nip type tandem photovoltaic cell as shown in Fig. 1 and Fig. 3, washing may be performed one or more times in the process of formation of the photovoltaic cell. Although the formed surface is washed at the aforementioned timing in the first embodiment, it may be washed after the film formation of the first i layer 8a or after the film formation of the second n layer 7b in the second photoelectric conversion unit 6b.

According to the method for manufacturing the photovoltaic cell 1 in the first embodiment of the invention, as described above, in the process after the first i layer 8a (the thickest one of the layers) in the first photoelectric conversion unit 6a (the bottom one of the photoelectric conversion units) formed on the first electrode 3 is formed and before the second i layer 8b (the thickest one of the layers) in the second photoelectric conversion unit 6b (the top one of the photoelectric conversion units) is formed, the surface of the first p layer 9a formed in the process is washed so that the pin hole P1 generated in the first photoelectric conversion unit 6a (the layers laminated before the washing) after a foreign substance is removed by the step of washing can be buried with the second photoelectric conversion unit 6b (the layers laminated after the washing). Particularly, since the i layer thicker than the p layer and the n layer is included in the second photoelectric conversion unit 6b burying the pin hole P1 (the layers with which the pin hole is buried), the parallel resistance Rₛₕ between the first electrode 3 and the second electrode 5 is not lowered remarkably, so that it is possible to efficiently prevent the deterioration of the photoelectric conversion performance caused by the adhesion of the foreign substance and the occurrence of leakage. (See "Comparison between Examples 1 to 4 and Comparative Example 1", "Comparison between Comparative Example 1 and Comparative Example 2", "Comparison between Comparative Example 1 and Comparative Example 3" and "Comparison between Comparative Example 1 and Comparative Example 4", which will be described later, by way of example)
The surface of the first i layer 8a or the second n layer 7b may be washed in place of the first p layer 9a. It is, however, more preferable to wash the surface of the first p layer 9a. (See "Comparison between Example 3 and Example 4", which will be described later, by way of example)

According to the method for manufacturing the photovoltaic cell 1 in the first embodiment of the invention, a reverse voltage is applied between the first electrode 3 and the second electrode 5 after the second electrode 5 is formed. In this case, the parallel resistance Rₛₕ between the first electrode 3 and the second electrode 5 is not lowered remarkably in the portion where the pin hole P1 is generated, as described above. Accordingly, leak sources can be removed by the application of the reverse voltage so as to further efficiently prevent the deterioration of the photoelectric conversion performance caused by the adhesion of the foreign substance and the occurrence of leakage.

According to the method for manufacturing the photovoltaic cell 1 in the first embodiment of the invention, hydrogen plasma treatment is applied to the washed surface so as to remove a superficial layer of the surface degraded by washing, so that the surface can be well joined with a layer that will be formed further thereon. It is therefore possible to improve the photoelectric conversion performance of the photovoltaic cell 1. As a result, it is possible to prevent the deterioration of the photoelectric conversion performance caused by the adhesion of the foreign substance. (See "Comparison between Example 1 and Example 2", which will be described later, by way of example)

According to the method for manufacturing the photovoltaic cell 1 in the first embodiment of the invention, the film thickness of the first p layer 9a to be washed (the layer to be washed) is formed to be thicker than a designed film thickness in advance, and the hydrogen plasma treatment is applied to the washed surface after the washing so that the film thickness of the first p layer 9a subjected to the washing (the washed layer) is made as large as the predetermined designed film thickness. It is therefore possible to prevent the film thickness of the first p layer 9a subjected to the washing (the washed layer) from being thinner than the predetermined designed film thickness due to the washing. (See "Comparison between Example 2 and Example 3", which will be described later, by way of example)

According to the method for manufacturing the photovoltaic cell 1 in the first embodiment of the invention, the washing is performed by bringing a brush roll as a washing roll into contact with the washed surface. It is therefore possible to perform washing on the washed surface surely. Thus, it is possible to efficiently prevent the deterioration of the photoelectric conversion performance caused by the adhesion of the foreign substance and the occurrence of leakage. (See "Comparison between Examples 1 to 4 and Comparative Example 1", which will be described later, by way of example)

### [Second Embodiment]

A method for manufacturing a photovoltaic cell in a second embodiment of the invention will be described below. A fundamental form in the method for manufacturing a photovoltaic cell in the second embodiment is the same as that in the method for manufacturing a photovoltaic cell in the first embodiment. Elements similar to those in the first embodiment will be described using similar reference signs and names to those in the first embodiment. Here, description will be made on a different configuration from that of the first embodiment.

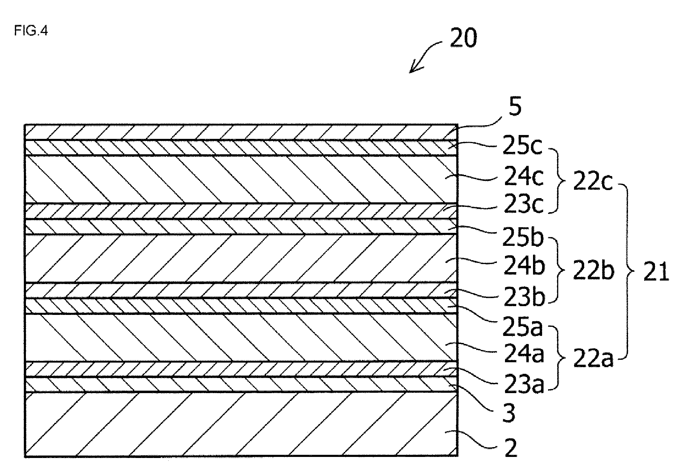

As shown in Fig. 4, a photovoltaic cell 20 in the second embodiment has a laminate structure in which a first electrode 3, a photoelectric conversion layer 21 and a second electrode 5 are laminated on one surface of a substrate 2 in this order.

The photoelectric conversion layer 21 has a first photoelectric conversion unit 22a laminated on the first electrode 3, a second photoelectric conversion unit 22b laminated on the first photoelectric conversion unit 22a, and a third photoelectric conversion unit 22c laminated on the second photoelectric conversion unit 22b. The photovoltaic cell 20 is of a triple type. The first photoelectric conversion unit 22a has a laminate structure in which a first n layer 23a, a first i layer 24a as a substantially intrinsic layer, and a first p layer 25a are laminated in this order. The first i layer 24a is thicker than the first n layer 23a and the first p layer 25a. The second photoelectric conversion unit 22b has a laminate structure in which a second n layer 23b, a second i layer 24b as a substantially intrinsic layer, and a second p layer 25b are laminated in this order. The second i layer 24b is thicker than the second n layer 23b and the second p layer 25b. The third photoelectric conversion unit 22c has a laminate structure in which a third n layer 23c, a third i layer 24c as a substantially intrinsic layer, and a third p layer 25c are laminated in this order. The third i layer 24c is thicker than the third n layer 23c and the third p layer 25c. Each photoelectric conversion unit may be arranged so that a p layer, an i layer and an n layer are laminated in this order.

a-SiO may be used for the n layer and the p layer in each photoelectric conversion unit. a-Si, a-SiGe, a-SiC, a-SiO, a-SiN, µc-Si, µc-SiGe, µc-SiC, µc-SiO, µc-SiN, etc. may be used for the i layer in each photoelectric conversion unit. The aforementioned materials for the i layer added with a suitable content of B, P, etc. may be used for the n layer and the p layer in each photoelectric conversion unit.

In addition, the photovoltaic cell 20 has an equivalent circuit similar to that of the first embodiment. When a reverse voltage is applied to such a photovoltaic cell 20 so as to make a current flow in an opposite direction to the pn junction, the current flows into the region of a parallel resistance Rₛₕ which has a comparatively low resistance. As a result, Joule heat is applied to the small parallel resistance Rₛₕ region, so that the leak occurrence portion can be removed.

The method for manufacturing the photovoltaic cell 20 in the second embodiment of the invention will be described. The first electrode 3 is formed as a film on the surface of the substrate 2. A plasma CVD method is used to form films of the first photoelectric conversion unit 22a in such a manner that the first n layer 23a is formed as a film so as to be laminated on the first electrode 3, and the first i layer 24a and the first p layer 25a are formed as films so as to be laminated on the first n layer 23a. Next, the surface of the first p layer 25a is washed in the same manner as in the first embodiment, and etching is performed on the washed surface.

After that, films of the second photoelectric conversion unit 22b are formed in such a manner that the second n layer 23b is formed as a film so as to be laminated on the first p layer 25a, the second i layer 24b is formed as a film so as to be laminated on the second n layer 23b, and the second p layer 25b is formed as a film so as to be laminated on the second i layer 24b. Further, films of the third photoelectric conversion unit 22c are formed in such a manner that the third n layer 23c is formed as a film so as to be laminated on the second p layer 25b, the third i layer 24c is formed as a film so as to be laminated on the third n layer 23c, and the third p layer 25c is formed as a film so as to be laminated on the third i layer 24c. The second electrode 5 is formed as a film so as to be laminated on the third p layer 25c. Incidentally, a sputtering method, a deposition method, a Cat-CVD method, an optical CVD method, etc. may be used for forming films of the layers in the first photoelectric conversion unit 22a, the second photoelectric conversion unit 22b, and the third photoelectric conversion unit 22c. In the second embodiment, the film thickness of each of the i layers is designed to be 100 nm to 200 nm, and the film thickness of each of the p layers and the n layers is designed to be 10 nm to 30 nm.
Although the example in which washing is performed once after the first p layer 25a is formed as a film is shown here as an example of an nip type triple-junction photovoltaic cell as shown in Fig. 4, washing may be performed one or more times in the process of formation of the photovoltaic cell. Although the formed surface is washed at the aforementioned timing in the second embodiment, it may be washed after the film formation of the first i layer 24a, after the film formation of the second n layer 23b, after the film formation of the second i layer 24b, after the film formation of the second p layer 25b or after the film formation of the third n layer 23c. In addition, even when the film thickness of an i layer in one photoelectric conversion unit does not reach 50 nm, it will go well if the total thickness of an n layer and a p layer is not smaller than 50 nm. In addition, for example, when two photoelectric conversion units are formed before washing and one photoelectric conversion unit is formed after the washing, it will go well if the total film thickness before the washing is not smaller than 50 nm. The same thing can be applied to the case where one photoelectric conversion unit is formed before washing and two photoelectric conversion units are formed after the washing.

According to the method for manufacturing the photovoltaic cell 20 in the second embodiment of the invention, as described above, similar effects to those of the first embodiment can be obtained in an nip type triple-junction photovoltaic cell.

### [Third Embodiment]

A method for manufacturing a photovoltaic cell in a third embodiment of the invention will be described below. A fundamental form in the method for manufacturing a photovoltaic cell according to the third embodiment is the same as that in the method for manufacturing a photovoltaic cell in the first embodiment. Elements similar to those in the first embodiment will be described using similar reference signs and names to those in the first embodiment. Here, description will be made on a different configuration from that of the first embodiment.

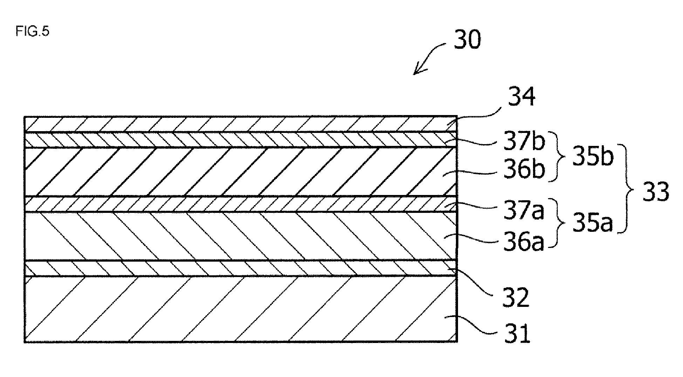

As shown in Fig. 5, a photovoltaic cell 30 in the third embodiment has a laminate structure in which a first electrode 32, a photoelectric conversion layer 33 and a second electrode 34 are laminated on one surface of a substrate 31 in this order. An impermeable plastic substrate is used as the substrate 31, and the second electrode 34 side serves as the light receiving side. In addition, similar materials to those for the substrate 2 in the first embodiment may be used for the substrate 31.

The first electrode 32 is arranged to be capable of reflecting sunlight. The surface of the first electrode 32 is formed into a textured shape to scatter incident sunlight from the light receiving side and increase the amount of absorption in the photoelectric conversion layer 33. Similar materials to those for the first electrode 3 and the second electrode 5 in the first embodiment may be used for the first electrode 32 and the second electrode 34.

The photoelectric conversion layer 33 has a first photoelectric conversion unit 35a laminated on the first electrode 32 and a second photoelectric conversion unit 35b laminated on the first photoelectric conversion unit 35a. The photovoltaic cell 30 is of a tandem type. The first photoelectric conversion unit 35a has a laminate structure in which a first p layer 36a and a first n layer 37a are laminated in this order. The first p layer 36a is thicker than the first n layer 37a. The second photoelectric conversion unit 35b has a laminate structure in which a second p layer 36b and a second n layer 37b are laminated in this order. The second p layer 36b is thicker than the second n layer 37b.

Similar materials to those for the first p layer 9a and the second p layer 9b in the first embodiment may be used for the first p layer 36a and the second p layer 36b respectively. Alternatively, compound based materials such as CIS, CIGS and CdTe may be used. Similar materials to those for the first n layer 7a and the second n layer 7b in the first embodiment may be used for the first n layer 37a and the second n layer 37b respectively. Alternatively, compound based materials such as CdS may be used when CIS, CIGS and CdTe based materials are used for the p layers. When one of a CIS layer and a CIGS layer is used as a p layer, it is preferable that the film thickness of the p layer is set in a range of from 1 µm to 3 µm. When a CdTe layer is used as a p layer, it is preferable that the film thickness of the p layer is set in a range of from 3 µm to 7 µm, but the film thickness does not have to be always set in that range. In addition, the sequence of film formation of a p layer and an n layer may be changed in the configuration where the n layer is thicker than the p layer. In this case, it is preferable that an n type CIS layer, an n type CIGS layer or an n type CdTe layer is applied to the n layer.

In addition, the photovoltaic cell 30 has an equivalent circuit similar to that of the photovoltaic cell 1 in the first embodiment. When a reverse voltage is applied to such a photovoltaic cell 30 so as to make a current flow in an opposite direction to the pn junction, the current flows into the region of a parallel resistance Rₛₕ which has a comparatively low resistance. As a result, Joule heat is applied to the small parallel resistance Rₛₕ region, so that the leak occurrence portion can be removed.

The method for manufacturing the photovoltaic cell 30 according to the third embodiment will be described. The first electrode 32 is formed as a film on the surface of the substrate 31. A deposition method is used to form films of the first photoelectric conversion unit 35a in such a manner that the first p layer 36a is formed as a film so as to be laminated on the first electrode 32, and the first n layer 37a is then formed as a film. Next, the surface of the first n layer 37a is washed in the same manner as in the first embodiment, and etching is performed on the washed surface.

After that, films of the second photoelectric conversion unit 35b are formed in such a manner that the second p layer 36b is formed as a film so as to be laminated on the first n layer 37a, and the second n layer 37b is formed as a film so as to be laminated on the second p layer 36b. The second electrode 34 is formed as a film so as to be laminated on the second n layer 37b. Incidentally, a sputtering method, a plasma CVD method, a Cat-CVD method, an optical CVD method, etc. may be used for forming films of the layers in the first photoelectric conversion unit 35a and the second photoelectric conversion unit 35b. In the third embodiment, the film thickness of each of the p layers is designed to be 1 µm to 3 µm, and the film thickness of each of the n layers is designed to be 50 nm to 100 nm.
Although the example in which washing is performed once after the first n layer 37a is formed as a film is shown here as an example of a pn type tandem photovoltaic cell in which a p layer is thicker than an n layer as shown in Fig. 5, washing may be performed one or more times in the process of formation of the photovoltaic cell. Although the formed surface is washed at the aforementioned timing in the third embodiment, it may be washed after the film formation of the first p layer 36a.

According to the method for manufacturing the photovoltaic cell 30 in the third embodiment of the invention, as described above, similar effects to those of the first embodiment can be obtained in a pn type tandem photovoltaic cell in which a p layer is thicker than an n layer.

### [Fourth Embodiment]

A method for manufacturing a photovoltaic cell in a fourth embodiment of the invention will be described below. A fundamental form in the method for manufacturing a photovoltaic cell in the fourth embodiment is the same as that in the method for manufacturing a photovoltaic cell in the third embodiment. Elements similar to those in the third embodiment will be described using similar reference signs and names to those in the third embodiment. Here, description will be made on a different configuration from that of the third embodiment.

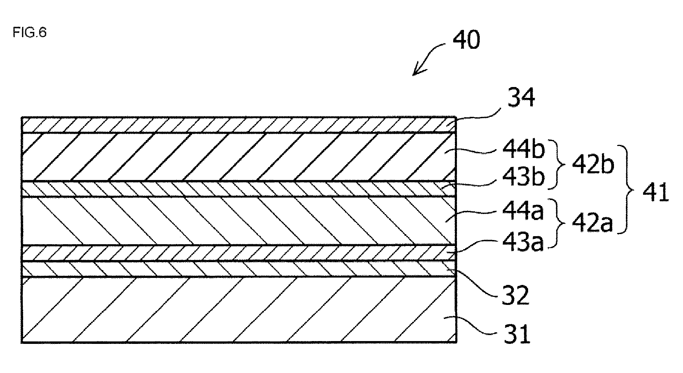

As shown in Fig. 6, a photovoltaic cell 40 in the fourth embodiment has a laminate structure in which a first electrode 32, a photoelectric conversion layer 41 and a second electrode 34 are laminated on one surface of a substrate 31 in this order.

The photoelectric conversion layer 41 has a first photoelectric conversion unit 42a laminated on the first electrode 32 and a second photoelectric conversion unit 42b laminated on the first photoelectric conversion unit 42a. The photovoltaic cell 40 is of a tandem type. The first photoelectric conversion unit 42a has a laminate structure in which a first p layer 43a and a first n layer 44a are laminated in this order. The first n layer 44a is thicker than the first p layer 43a. The second photoelectric conversion unit 42b has a laminate structure in which a second p layer 43b and a second n layer 44b are laminated in this order. The second n layer 44b is thicker than the second p layer 43b.

Similar materials to those for the first n layer 37a and the second n layer 37b in the third embodiment may be used respectively for the first p layer 43a and the second p layer 43b whose conductivity type is reversed to that of the first n layer 37a and the second n layer 37b. Similar materials to those for the first p layer 36a and the second p layer 36b in the third embodiment may be used respectively for the first n layer 44a and the second n layer 44b whose conductivity type is reversed to that of the first p layer 36a and the second p layer 36b. In addition, the sequence of film formation of a p layer and an n layer may be changed in the configuration where the p layer is thicker than the n layer. In this case, it is preferable that a p type CIS layer, a p type CIGS layer or a p type CdTe layer is applied to the p layer.

In addition, the photovoltaic cell 40 has an equivalent circuit similar to that of the photovoltaic cell 30 in the third embodiment. When a reverse voltage is applied to such a photovoltaic cell 40 so as to make a current flow in an opposite direction to the pn junction, the current flows into the region of a parallel resistance Rₛₕ which has a comparatively low resistance. As a result, Joule heat is applied to the small parallel resistance Rₛₕ region, so that the leak occurrence portion can be removed.

The method for manufacturing the photovoltaic cell 40 according to the fourth embodiment will be described. The first electrode 32 is formed as a film on the surface of the substrate 31. A deposition method is used to form films of the first photoelectric conversion unit 42a in such a manner that the first p layer 43a is formed as a film so as to be laminated on the first electrode 32, and the first n layer 44a is formed as a film so as to be laminated on the first p layer 43a. Next, the surface of the first n layer 44a is washed in the same manner as in the third embodiment, and etching is performed on the washed surface.

After that, films of the second photoelectric conversion unit 42b are formed in such a manner that the second p layer 43b is formed as a film so as to be laminated on the first n layer 44a, and the second n layer 44b is formed as a film so as to be laminated on the second p layer 43b. The second electrode 34 is formed as a film so as to be laminated on the second n layer 44b. Incidentally, a sputtering method, a plasma CVD method, a Cat-CVD method, an optical CVD method, etc. may be used for forming the films in the first photoelectric conversion unit 42a and the second photoelectric conversion unit 42b. In the fourth embodiment, the film thickness of each of the p layers is designed to be 50 nm to 100 nm, and the film thickness of each of the n layers is designed to be 1 µm to 3 µm.
Although the example in which washing is performed once after the first p layer 44a is formed as a film is shown here as an example of a pn type tandem photovoltaic cell in which an n layer is thicker than a p layer as shown in Fig. 6, washing may be performed one or more times in the process of formation of the photovoltaic cell. Although the formed surface is washed at the aforementioned timing in the fourth embodiment, it may be washed after the film formation of the second p layer 43b.

According to the method for manufacturing the photovoltaic cell 40 in the fourth embodiment of the invention, as described above, similar effects to those of the third embodiment can be obtained in a pn type tandem photovoltaic cell in which an n layer is thicker than a p layer.

Although description has been made so far on the first to fourth embodiments of the invention, the invention is not limited to the aforementioned embodiments, but various modifications and changes may be made thereon based on the technical ideas of the invention.

As a first modification of the invention, configuration may be made in such a manner that the photoelectric conversion layer 4 or 21 in the first or second embodiment has four or more layers of photoelectric conversion units. In this case, it will go well if the surface of one of layers is washed at least once and the washed surface is etched after an i layer having a film thickness not smaller than 50 nm is formed in the bottom photoelectric conversion unit formed on a substrate and before an i layer having a film thickness not smaller than 50 nm is formed in the top photoelectric conversion unit. Similar effects to those in the first and second embodiments of the invention can be obtained.

As a second modification of the invention, configuration may be made in such a manner that the photoelectric conversion layer 33 in the third embodiment has three or more layers of photoelectric conversion units. In this case, it will go well if the surface of one of layers is washed at least once and the washed surface is etched after a p layer having a film thickness not smaller than 50 nm is formed in the bottom photoelectric conversion unit formed on a substrate and before a p layer having a film thickness not smaller than 50 nm is formed in the top photoelectric conversion unit. Similar effects to those in the third embodiment of the invention can be obtained.

As a third modification of the invention, configuration may be made in such a manner that the photoelectric conversion layer 41 in the fourth embodiment has three or more layers of photoelectric conversion units. In this case, it will go well if the surface of one of layers is washed at least once and the washed surface is etched after an n layer having a film thickness not smaller than 50 nm is formed in the bottom photoelectric conversion unit formed on a substrate and before an n layer having a film thickness not smaller than 50 nm is formed in the top photoelectric conversion unit. Similar effects to those in the fourth embodiment of the invention can be obtained.

As a fourth modification of the invention, Ar (argon) plasma treatment, CF4 plasma treatment, etc. in place of the hydrogen plasma treatment may be applied to the washed surface in the first to fourth embodiments. Similar effects to those in the first to fourth embodiments of the invention can be obtained.

As a fifth modification of the invention, the washing roll in the first to fourth embodiments may be a sticky roll or a sponge roll. Similar effects to those in the first to fourth embodiments of the invention can be obtained.

As a sixth modification of the invention, the washing using the washing roll in the first to fourth embodiments may be replaced by washing based on blowing air, ultrasonic washing in a state in which the washed surface is soaked in liquid, or the like. Similar effects to those in the first to sixth embodiments of the invention can be obtained.

As a seventh modification of the invention, a permeable substrate may be used as the substrates 2, 21, 31 and 51 in the first to fourth embodiments so that the first electrode side can serve as the light receiving side. Similar effects to those in the first to fourth embodiments of the invention can be obtained.

### [Example 1]

In Example 1 of the invention, used is a photovoltaic cell which is manufactured in the same conditions as in the first embodiment, except that the hydrogen plasma treatment is not performed but a reverse voltage is applied to make a current flow in an opposite direction to the pn junction after the surface of the first p layer 9a formed to have a designed film thickness is washed. As to such a photovoltaic cell of Example 1, the IV characteristic under 1 sun is calculated by a solar simulator, and an open voltage V_{oc}, a short-circuit current I_{sc}, a fill factor FF and a conversion efficiency E_{ff} are measured.

### [Example 2]

In Example 2 of the invention, used is a photovoltaic cell which is manufactured in the same manner as in Example 1, except that the hydrogen plasma treatment is performed after the surface of the first p layer 9a formed to have a designed film thickness is washed. Upon such a photovoltaic cell of Example 2, similar measurements to those in Example 1 are carried out.

### [Example 3]

In Example 3 of the invention, used is a photovoltaic cell which is manufactured in the same manner as in Example 1, except that the hydrogen plasma treatment is performed after the surface of the first p layer 9a formed to be thicker than a designed film thickness is washed as in the first embodiment. Upon such a photovoltaic cell of Example 3, similar measurements to those in Example 1 are carried out.

### [Example 4]

In Example 4 of the invention, used is a photovoltaic cell which is manufactured in the same manner as in Example 1, except that instead of washing the surface of the first p layer 9a, the first i layer 8a is washed and the hydrogen plasma treatment is performed. Upon such a photovoltaic cell of Example 4, similar measurements to those in Example 1 are carried out.

### [Comparative Example 1]

In Comparative Example 1, used is a photovoltaic cell which is manufactured in the same manner as in Example 1, except that the surface of the first p layer 9a is not washed. Upon such a photovoltaic cell of Comparative Example 1, similar measurements to those in Example 1 are carried out.

### [Comparative Example 2]

In Comparative Example 2, used is a photovoltaic cell which is manufactured in the same manner as in Example 1, except that instead of washing the surface of the first p layer 9a, the first n layer 7a is washed and the hydrogen plasma treatment is performed. Upon such photovoltaic cell of Comparative Example 2, similar measurements to those in Example 1 are carried out.

### [Comparative Example 3]

In Comparative Example 3, used is a photovoltaic cell which is manufactured in the same manner as in Example 1, except that instead of washing the surface of the first p layer 9a, the surface of the first i layer 8a is washed in the state where a half of the first i layer 8a has been formed, and the other half of the first i layer 8a is formed after the hydrogen plasma treatment has been performed. Upon such a photovoltaic cell of Comparative Example 3, similar measurements to those in Example 1 are carried out.

### [Comparative Example 4]

In Comparative Example 4, used is a photovoltaic cell which is manufactured in the same manner as in Example 1, except that instead of washing the surface of the first p layer 9a, the surface of the first i layer 8a is washed and the hydrogen plasma treatment is performed. Upon such a photovoltaic cell of Comparative Example 4, similar measurements to those in Example 1 are carried out.

Table 1 shows the ratios of the measured results in Example 1 to Example 4 and Comparative Examples 2 to 4 to the measured results in Comparative Example 1 when normalization is carried out using the measured results of respective properties in Comparative Example 1 as a reference value 1.00.

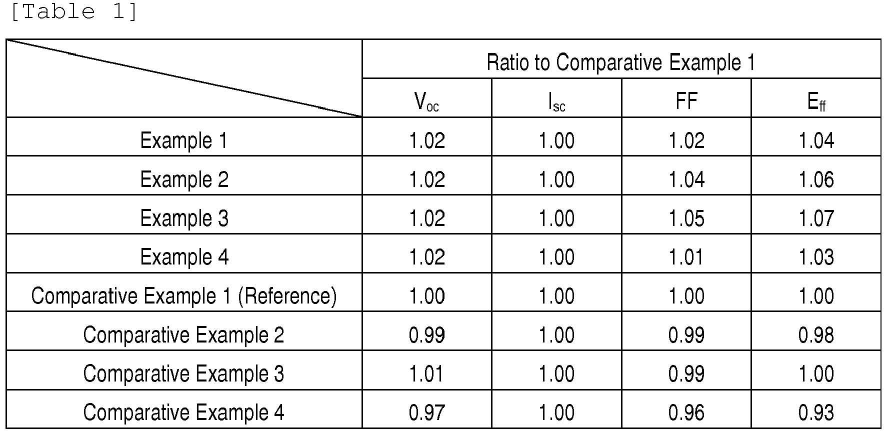

### [Comparison between Examples 1 to 4 and Comparative Example 1]

Referring to Table 1, in Examples 1 to 4 where washing is performed, the open voltage V_{oc}, the fill factor FF and the conversion efficiency E_{ff} are improved as compared with those in Comparative Example 1 where washing is not performed.
It is therefore proved that the deterioration of the photoelectric conversion performance caused by the adhesion of a foreign substance and the occurrence of leakage can be efficiently prevented by washing.

### [Comparison between Example 1 and Example 2]

Referring to Table 1, in Example 2 where the hydrogen plasma treatment is performed, the fill factor FF and the conversion efficiency E_{ff} are improved as compared with those in Example 1 where the hydrogen plasma treatment is not performed. It can be considered that this is because the washed surface contaminated due to contact with the washing roll during the washing is removed by the hydrogen plasma treatment so that the junction interface between the units of the photovoltaic cell is improved.
It is therefore proved that the superficial layer of the surface degraded by washing is removed by hydrogen plasma treatment so that the surface can be well joined to a layer formed further thereon, so that the photoelectric conversion performance of the photovoltaic cell can be improved, and the deterioration of the photoelectric conversion performance caused by the adhesion of a foreign substance can be prevented.

### [Comparison between Example 2 and Example 3]

Referring to Table 1, in Example 3 where the film thickness of the first p layer 9a is made thicker than the designed film thickness, the fill factor FF and the conversion efficiency E_{ff} are improved as compared with those in Example 2 where the film thickness of the first p layer 9a is made as thick as the designed film thickness. It can be considered that this is because the hydrogen plasma treatment is not satisfactory in Example 2 as compared with that in Example 3 since the film thickness of the first p layer 9a is made thinner than the designed film thickness by the hydrogen plasma treatment.
It is therefore proved that when the film thickness of the first p layer 9a is made thicker than the designed film thickness as in Example 3, the hydrogen plasma treatment can be performed satisfactorily to secure the designed film thickness of the first p layer 9a so that the washed surface can be well joined to a layer formed further thereon, so that the photoelectric conversion performance of the photovoltaic cell can be further improved, with the result that the deterioration of the photoelectric conversion performance caused by the adhesion of a foreign substance can be prevented surely.

### [Comparison between Examples 1 to 3 and Example 4]

Referring to Table 1, the fill factor FF and the conversion efficiency E_{ff} are lowered in Example 4 as compared with those in Examples 1 to 3. It can be considered that this is because the junction state of the p/i interface layer is changed by washing since the junction state of the p/i interface layer is relevant to the characteristic of the photovoltaic cell. Incidentally, the same phenomenon is conceived also in the case of the n/i interface layer. Particularly in Example 3, washing is performed in the np reverse junction portion between the photoelectric conversion units. In a multi-junction type photovoltaic cell, an np reverse junction portion does not have a rectification function but has an ohmic function based on the adjustment of the doping density or the like so that the influence of impurities and so on is small as compared with that in interfaces among layers within a photoelectric conversion unit forming a pn junction. It can be therefore considered that the characteristic of the photovoltaic cell in Examples 1 to 3 is improved as compared with that in Example 4.

### [Comparison between Comparative Example 1 and Comparative Example 2]

Referring to Table 1, in Comparative Example 2 where the first n layer 7a is washed and the hydrogen plasma treatment is performed, the conversion efficiency E_{ff} is lowered as compared with that in Comparative Example 1 where washing and hydrogen plasma treatment are not performed. It can be considered that this is because, when washing is performed after the formation of the first n layer 7a, desorption of a foreign substance occurs after formation of the first i layer 8a after the washing so as to lead to generation of a place where the first electrode 3 and the second electrode 5 are locally close to or in contact with each other, so that the effect of leak removal cannot be obtained satisfactorily.

### [Comparison between Comparative Example 1 and Comparative Example 3]

Referring to Table 1, in Comparative Example 3 where washing and hydrogen plasma treatment are performed during the film formation of the first i layer 8a, the conversion efficiency E_{ff} is the same level as that in Comparative Example 1 where washing and hydrogen plasma treatment are not performed. It can be considered that this is because, due to the washing performed during the formation of the first i layer 8a, the effect of the washing indeed appears but the effect is lowered because the film thickness before the washing is thinner than that in Example 3. Further, it can be considered that this is because the hydrogen plasma treatment is indeed performed on the washed surface, but the first i layer 8a in Comparative Example 3 is contaminated and impurities are mixed into the film, as compared with the first i layer 8a formed continuously, with the result that the film quality of the first i layer 8a in Example 3 is degraded.

### [Comparison between Comparative Example 1 and Comparative Example 4]

Referring to Table 1, in Comparative Example 4 where washing and hydrogen plasma treatment are performed on the second i layer 8b, the conversion efficiency E_{ff} is lowered on a large scale as compared with that in Comparative Example 1 where washing and hydrogen plasma treatment are not performed. This is because, in Comparative Example 4 where washing is performed after the film formation of the second i layer 8b so as to remove a foreign substance, the first electrode 3 is partially exposed or the film thickness of the layer formed on the first electrode 3 is locally extremely thin. Accordingly, the second p layer 9b is formed as a film in such a state. In this case, the film thickness of the second p layer is about 10 nm to 30 nm, that is not larger than one tenth of the total film thickness (about 250 nm to 600 nm) from the first n layer 7a to the second i layer 8b. Thus, the region where the first electrode 3 is exposed or the region where the film on the first electrode 3 is locally extremely thin cannot be protected satisfactorily. It can be therefore considered that the first electrode 3 and the second electrode 5 touch each other or only an extremely thin photoelectric conversion layer is interposed therebetween, so that leakage cannot be removed satisfactorily by the application of a reverse voltage, with the result that the leakage increases on a large scale.

Thus, in the aforementioned [Comparison between Comparative Example 1 and Comparative Example 2], [Comparison between Comparative Example 1 and Comparative Example 3] and [Comparison between Comparative Example 1 and Comparative Example 4], it is not possible to satisfactorily confirm the effect that the deterioration of the photoelectric conversion performance caused by the adhesion of a foreign substance and the occurrence of leakage can be prevented efficiently.
Accordingly, it is proved that the deterioration of the photoelectric conversion performance caused by the adhesion of a foreign substance and the occurrence of leakage can be prevented efficiently when a surface of a layer formed in a process after the thickest one of the layers in the bottom one of the photoelectric conversion units formed on the first electrode is formed and before the thickest one of the layers in the top one of the photoelectric conversion units is formed is washed in the process.

### REFERENCE SIGNS LIST

- 1,20,30,40: photovoltaic cell
- 2,31: substrate
- 3,32: first electrode
- 4,21,33,41: photoelectric conversion device
- 5,34: second electrode
- 6a,22a,35a,42a: first photoelectric conversion unit
- 6b,22b,35b,42b: second photoelectric conversion unit
- 7a,23a,37a,44a: first n layer
- 7b,23b,37b,44b: second n layer
- 8a,24a: first i layer
- 8b,24b: second i layer
- 9a,25a,36a,43a: first p layer
- 9b,25b,36b,43b: second p layer
- 22c: third photoelectric conversion unit
- 23c: third n layer
- 24c: third i layer
- 25c: third p layer
- P1,P2: pin hole
- Iₚₕ: constant current source
- Rₛ: serial resistance
- Rₛₕ: parallel resistance
- D: diode
- V_{oc}: open voltage
- I_{sc}: short-circuit current
- FF: fill factor
- E_{ff}: conversion efficiency
- A: foreign substance

## Claims

1. A method for manufacturing a photovoltaic cell including a structure in which a first electrode, a photoelectric conversion layer and a second electrode are formed on one surface of a substrate in this order, and the photoelectric conversion layer is consisted of plural photoelectric conversion units and arranged as a multi-junction type photoelectric conversion layer, and the photoelectric conversion units are consisted of plural layers,_
the method comprising
one cleaning step between fabrication process of the layer which is the thickest in the bottom photovoltaic conversion unit and in the top photovoltaic conversion unit, and the surface of a layer during fabricating a photoelectric conversion unit is cleaned in that process.

2. The method for manufacturing a photovoltaic cell according to Claim 1, further comprising:
applying a reverse voltage between the first electrode and the second electrode after the second electrode is formed.

3. The method for manufacturing a photovoltaic cell according to Claim 1 or 2, further comprising:
exposing the surface which is cleaned in the cleaning step to hydrogen , argon and/or CF4 plasma.

4. The method for manufacturing a photovoltaic cell according to Claim 3, wherein the film thickness of the layer which is cleaned is fabricated thicker than that of the design value, and then the layer is etched by exposing hydrogen, argon and/or CF4 plasma treatment to fit the film thickness of the layer as the design value.

5. The method for manufacturing a photovoltaic cell according to any one of Claims 1 through 4, wherein the cleaning step is progressed by contacting the cleaning roll to the surface physically.

6. The method for manufacturing a photovoltaic cell according to Claim 5, wherein the cleaning roll is selected in a brush roll, an adhesive roll or a sponge roll.

7. The method for manufacturing a photovoltaic cell according to any one of Claims 1 through 4, wherein the cleaning step is progressed by blowing air to the surface or ultrasonic cleaning.

8. The method for manufacturing a photovoltaic cell according to any one of Claims 1 through 7, wherein each of the photoelectric conversion units has a pin junction structure or an nip junction structure.

9. The method for manufacturing a photovoltaic cell according to Claim 8, wherein plural i layers in each of the photoelectric conversion units are made of non crystalline silicon , and the film thickness of each i layer is the thickest in each photoelectric conversion unit.

10. The method for manufacturing a photovoltaic cell according to Claim 9, wherein the i layer provided in at least one of the photoelectric conversion units is an amorphous silicon layer or an amorphous silicon alloy layer, and the film thickness of the i layer is in a range from 50 nm to 500 nm.

11. The method for manufacturing a photovoltaic cell according to Claim 9, wherein the i layer provided in at least one of the photoelectric conversion units is a microcrystal silicon layer or a microcrystal silicon alloy layer, and the film thickness of the i layer is in a range from 1 µm to 3 µm.

12. The method for manufacturing a photovoltaic cell according to any one of Claims 1 through 7, wherein each of the photoelectric conversion units has a pn junction structure or an np junction structure.

13. The method for manufacturing a photovoltaic cell according to Claim 12, wherein a p layer provided in each of the photoelectric conversion units is selected in a CIS layer, a CIGS layer or a CdTe layer, and the film thickness of the p layer is thicker than that of the n layer in the photoelectric conversion unit.

14. The method for manufacturing a photovoltaic cell according to Claim 13, wherein the p layer provided in at least one of the photoelectric conversion units is a CIS layer or a CIGS layer, and the film thickness of the p layer is in a range from 1 µm to 3 µm.

15. The method for manufacturing a photovoltaic cell according to Claim 13, wherein the p layer provided in at least one of the photoelectric conversion units is a CdTe layer, and the film thickness of the p layer is in a range from 3 µm to 7 µm.

16. The method for manufacturing a photovoltaic cell according to any one of Claims 8 through 15, wherein the cleaning step is progressed at the surface of an np reverse junction.

## Amended claims

### Amended claims under Art. 19.1 PCT

1. A method for manufacturing a photovoltaic cell including a structure in which a first electrode, a photoelectric conversion layer and a second electrode are formed on one surface of a substrate in this order, the photoelectric conversion layer includes a plurality of photoelectric conversion units that are arranged as a multi-junction type photoelectric conversion layer, and the photoelectric conversion units include a plurality of layers,
the method comprising:
after forming the thickest layer in the plurality of layers in the bottom photovoltaic conversion unit formed on the first electrode and before forming the thickest layer in the plurality of layers in the top photovoltaic conversion unit, cleaning a surface of a layer during fabricating the photoelectric conversion unit.

2. (Amended) The method for manufacturing a photovoltaic cell according to Claim 1, wherein
each of the photoelectric conversion units has an nip junction structure, and
in the cleaning, after forming the i layer in the bottom photoelectric conversion units, the surface of the i layer, is cleaned.

3. (Amended) The method for manufacturing a photovoltaic cell according to Claim 1, wherein
each of the photoelectric conversion units has an nip junction structure, and
in the cleaning, after forming the n layer in the top photoelectric conversion units, the surface of the n layer is cleaned.

4. (Amended) The method for manufacturing a photovoltaic cell according to Claim 1, further comprising:
applying a reverse voltage between the first electrode and the second electrode after the second electrode is formed.

5. (Amended) The method for manufacturing a photovoltaic cell according to Claim 1 or 4, further comprising:
exposing the surface which is cleaned to be subject to hydrogen plasma treatment, argon plasma treatment and/or CF4 plasma treatment after cleaning.

6. (Amended) The method for manufacturing a photovoltaic cell according to Claim 5, wherein
the film thickness of the layer which is cleaned is formed to be thicker in advance than a designed thickness before cleaning, and
the surface which is cleaned is subject to hydrogen plasma treatment, argon plasma treatment and/or CF4 plasma treatment so that the film thickness of the layer becomes the design value after cleaning.

7. (Amended) The method for manufacturing a photovoltaic cell according to any one of Claim 1 and Claims 4 through 6, wherein in the cleaning, the cleaning roll touches in contact with the surface physically.

8. (Amended) The method for manufacturing a photovoltaic cell according to Claim 7, wherein
the cleaning roll is a brush roll, an adhesive roll, or a sponge roll.

9. (Amended) The method for manufacturing a photovoltaic cell according to any one of Claim 1 and Claims 4 through 6, wherein in the cleaning, the air is blown to the surface, or ultrasonic wave is irradiated with being soaked in a liquid.

10. (Amended) The method for manufacturing a photovoltaic cell according to any one of Claim 1 and Claims 4 through 9, wherein each of the photoelectric conversion units has a pin junction structure or an nip junction structure.

11. (Amended) The method for manufacturing a photovoltaic cell according to Claim 10, wherein
the i layer in each of the photoelectric conversion units is made of non-crystalline silicon, and
the film thickness of the i layer is the thickest among the p layer, the i layer and the n layer in each photoelectric conversion unit.

12. (Amended) The method for manufacturing a photovoltaic cell according to Claim 11, wherein
the i layer provided in at least one of the photoelectric conversion units is an amorphous silicon layer, or an amorphous silicon alloy layer, and
the film thickness of the i layer is in a range from 50 nm to 500 nm.

13. (Amended) The method for manufacturing a photovoltaic cell according to Claim 11, wherein
the i layer provided in at least one of the photoelectric conversion units is a microcrystal silicon layer, or a microcrystal silicon alloy layer, and
the film thickness of the i layer is in a range from 1 µm to 3 µm.

14. (Amended) The method for manufacturing a photovoltaic cell according to any one of Claim 1 and Claims 4 through 9, wherein
each of the photoelectric conversion units has a pn junction structure or an np junction structure.

15. (Amended) The method for manufacturing a photovoltaic cell according to Claim 14, wherein
the p layer in each of the photoelectric conversion units is any one of a CIS layer, a CIGS layer, and a CdTe layer, and
the film thickness of the p layer is thicker than that of the n layer in the photoelectric conversion unit.

16. (Amended) The method for manufacturing a photovoltaic cell according to Claim 15, wherein
the p layer provided in at least one of the photoelectric conversion units is a CIS layer or a CIGS layer, and
the film thickness of the p layer is in a range from 1 µm to 3 µm.

17. (Added) The method for manufacturing a photovoltaic cell according to Claim 15, wherein
the p layer provided in at least one of the photoelectric conversion units is a CdTe layer, and
the film thickness of the p layer is in a range from 3 µm to 7 µm.

18. (Added) The method for manufacturing a photovoltaic cell according to any one of Claims 10 through 17, wherein
the cleaning is carried out between forming an n layer and forming a p layer of an up reverse junction.
